# EUROPEAN PATENT SPECIFICATION

(11) **EP 4 397 154 B1**
(45) Date of publication and mention of the grant of the patent: **27.05.2026**
(21) Application number: 22863738.5
(22) Date of filing: 29.08.2022
(51) Int. Cl.: H10N 70/00, H10B 63/00

(54) **NON-VOLATILE RESISTIVE RANDOM-ACCESS MEMORY AND A MANUFACTURING METHOD THEREOF**
NICHTFLÜCHTIGER RESISTIVER DIREKTZUGRIFFSPEICHER UND HERSTELLUNGSVERFAHREN DAFÜR
MÉMOIRE VIVE RÉSISTIVE NON VOLATILE ET SON PROCÉDÉ DE FABRICATION

(30) Priority: 30.08.2021 ZA 202106263
(43) Date of publication of application: 10.07.2024
(73) Proprietor: University of South Africa, 0002 Pretoria (ZA)
(72) Inventor: VALLABHAPURAPU, Sreedevi, 0002 Pretoria (ZA); VALLABHAPURAPU, Vijaya Srinivasu, 0002 Pretoria (ZA); DLAMINI, Zolile Wiseman, 0002 Pretoria (ZA)
(74) Representative: Manna, Sara
(86) International application number: PCT/IB2022/058064
(87) International publication number: WO 2023/031760

(56) References cited:
- WO-A1-2020/109991
- KR-A- 20210 062 998
- ZHANG PENG ET AL: "Coexistence of memory and threshold switching behaviors in natural milk-based organic memristor", vol. 8, no. 6, 1 June 2021 (2021-06-01), pages 066301, XP093043354, Retrieved from the Internet <URL:https://iopscience.iop.org/article/10.1088/2053-1591/ac03ed/pdf> DOI: 10.1088/2053-1591/ac03ed
- GUO YUANYANG ET AL: "Ultrafast degradable resistive switching memory based on [alpha]-lactose thin films", ORGANIC ELECTRONICS, ELSEVIER, AMSTERDAM, NL, vol. 83, 17 April 2020 (2020-04-17), XP086189292, ISSN: 1566-1199, [retrieved on 20200417], DOI: 10.1016/J.ORGEL.2020.105750
- ZHANG PENG, ZHANG JIAHUI, WANG KUNJIE, WANG LI, LIU XIANRONG, JING YAN, XU BENHUA: "Coexistence of memory and threshold switching behaviors in natural milk-based organic memristor", MATERIALS RESEARCH EXPRESS, vol. 8, no. 6, 1 June 2021 (2021-06-01), pages 066301, XP093043354, DOI: 10.1088/2053-1591/ac03ed

## Description

### BACKGROUND TO THE INVENTION

This invention relates to a non-volatile resistive random-access memory (ReRAM), as well as to a method of manufacturing a non-volatile resistive random-access memory.

Generally, a ReRAM is a two-terminal, and two-dimensional (2D) memory device that utilizes an active layer (switching layer), such as a thin-film sandwiched between two electrodes, namely, a bottom and a top electrode. The active layer is initially at a high resistive state (HRS), and when a voltage is applied to one of the electrodes while the other electrode is grounded, the active layer changes from a HRS to a low resistive state (LRS) - this is called the forming (or electroforming) process. These two resistive states are electrically interchangeable, and they are interpreted as binary codes 0 and 1, which resemble the OFF- and ON- states of a memory device. This is the operating principle of ReRAM devices.

The writing and erase process in ReRAM devices is associated with the resistive switch from HRS-to-LRS, during the SET process. In contrast, the erase process is related to the switching from LRS-to-HRS, during the RESET process.

CN108831993B relates to a kind of resistance-variable storing device including a bottom electrode, a top electrode and a dielectric layer arranged between the bottom electrode and the top electrode. The dielectric layer is composed of a bio-based material of doped quantum dot. Further, the bio-based material may be fibroin or chitosan, and the bottom electrode can be an ITO or AZO electrode.

CN105633112A describes a super-light resistive random-access memory comprising of a metal thin-film electrode, a first silk protein film and a second silk protein film cover, an upper layer and a lower layer of the metal thin-film electrode. The light silk protein is used as a substrate and is also used as a resistive material so that a resistive random-access memory with a mass per unit of 4mg/cm² can be obtained.

CN107425119A relates to a resistive neurobionics device with organic-biological compatibility including an ito glass substrate, organic protein film and Ag electrode films.

US9105575B2 relates to a method for fabricating a semiconductor device. A first insulation layer is formed over a substrate. Hydrophilic particles may be coated over the first insulation layer. These hydrophilic particles may comprise micelles or a hydrophilic polymer.

US2014/0264224 relates to a resistive random-access memory cell including a first layer operable as a first electrode, a second layer operable as a second electrode, and a third layer operable as a resistive switching layer and disposed between the first layer and the second layer. The third layer includes arrays of metal nanoparticles. The arrays of metal nanoparticles can be formed using a micelle solution.

The document GUO YUANYANG ET AL: "Ultrafast degradable resistive switching memory based on [alpha]-lactose thin films",ORGANIC ELECTRONICS, ELSEVIER, AMSTERDAM, NL, vol. 83, article 105750, 17 April 2020, discloses thin films of α -lactose from milk as the solid electrolyte layer in resistive switching memory devices on a glass substrate. The document ZHANG PENG ET AL: "Coexistence of memory and threshold switching behaviors in natural milk-based organic memristor",MATERIALS RESEARCH EXPRESS,vol. 8, no. 6, article 066301, 4 June 2021 discloses that dense and smooth milk films were deposited on a Pt/SiO2/ Si substrate by a spin-coating method and resistive switching devices based on milk films with the configuration of Ag/milk/Pt/SiO2/Si were fabricated.

It is an object of this invention to provide a non-volatile resistive random-access memory (ReRAM) that is environmentally friendly and/or bio-degradable.

It is a further object of this invention to provide a ReRAM which will be a useful alternative to existing ReRAM.

### SUMMARY OF THE INVENTION

In accordance with a first aspect of the invention there is provided a flexible non-volatile resistive random-access memory (ReRAM) or a resistive switching memory, which includes:
a first electrode;
a second electrode; and
a switching layer which is located between the first and second electrode, wherein the switching layer
   (i) contains milk or is milk-based, or
   (ii) contains an emulsion containing lactose, fat, protein and water.

The term "contains" or "containing" should be interpreted to include the possibility of additional, unnamed elements. In other words the switching layer may include other elements in addition to (i) milk or (ii) the emulsion mentioned above. In other words, the emulsion may include other elements in addition to lactose fat, protein and water, such as minerals (e.g. salts).

The milk may be animal milk. The animal milk may be cow milk, more specifically natural cow milk.

Typically, the emulsion may further include a mineral(s) and a vitamin(s).

In particular, the emulsion may contain water, fat, fatty acids, casein, sugar (lactose), serum proteins, calcium, phosphorus, potassium, iron, magnesium, copper, and a vitamin.

The resistive random-access memory may be a resistive random-access memory module.

The switching/active layer may be a dielectric of the ReRAM.

The switching/active layer may be configured to perform a switching operation (i.e. switching between high and low resistive states) according to an applied voltage.

The switching/active layer may be in the form of a film (e.g. a thin film).

The switching/active layer may be coated/applied onto the first electrode.

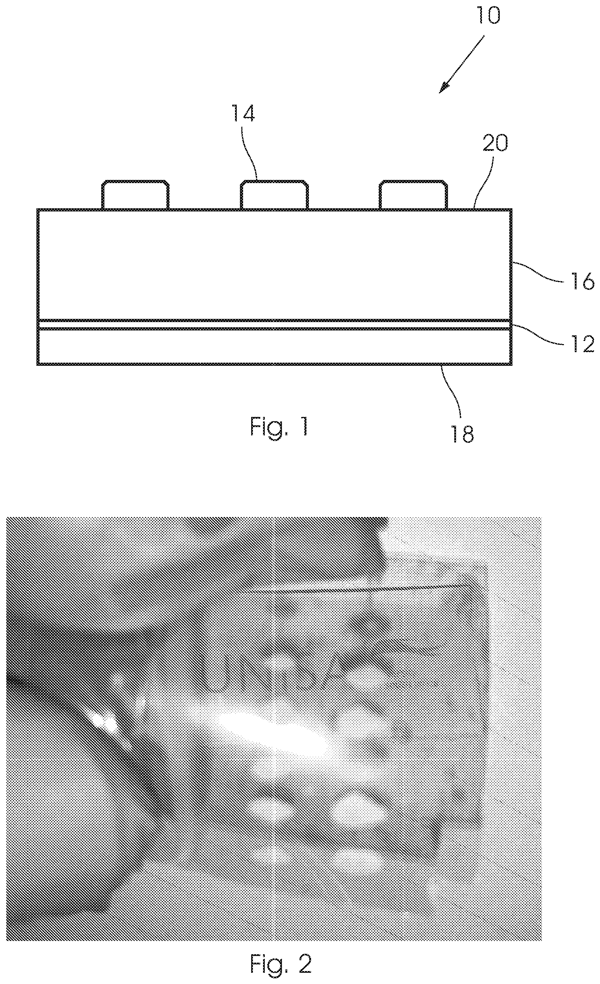

The second electrode may be placed/applied/provided over the switching/active layer such that the switching/active layer is located/wedged in-between the two electrodes (e.g. as shown in Figure 1).

The first electrode may be made, at least partially, from indium-doped tin oxide (ITO).

The first electrode may be coated/provided on a substrate, more specifically a PET (polyethylene terephthalate) substrate. The substrate may therefore form part of the ReRAM.

The second electrode may be made, at least partially, from a metal such as titanium, silver, aluminium, preferably silver. The second electrode may therefore be a metal electrode.

In accordance with a second aspect of the invention there is provided a non-volatile resistive random-access memory (ReRAM) switching layer composition which includes:
milk; or
an emulsion containing lactose, fat, protein and water.

In accordance with a third aspect of the invention there is provided a method for manufacturing a non-volatile resistive random-access memory (ReRAM), wherein the method includes:
providing a switching layer between a first electrode and a second electrode on a flexible substrate, wherein the switching layer contains
milk, or
an emulsion containing lactose, fat, protein and water.

The method may more specifically include applying the switching layer onto the first electrode. More specifically, the method may include applying the switching layer onto a substrate on which the first electrode is formed/provided.

The method may include dipping the first electrode into milk or the emulsion and allowing it to dry, to thereby allow the milk or emulsion to form the switching layer on/over the first electrode. More specifically, the method may include coating a substrate with the first electrode, so that the first electrode is formed on the substrate, and dipping the first electrode and substrate into milk or the emulsion and allowing it to dry, to thereby allow the milk or emulsion to form the switching layer on/over the first electrode. The first electrode may be made, at least partially, from indium-doped tin oxide (ITO) The method may include depositing/applying the second electrode onto the first electrode such that the switching layer is positioned/wedged in-between to thereby separate the layers. The second electrode may be made, at least partially, from metal such as titanium, silver or aluminium, preferably silver. The second electrode may therefore be a metal electrode. The method may include forming the second electrode by depositing silver paste onto the first electrode, such that the switching layer is positioned/wedged in-between the first electrode and the silver, wherein the silver therefore forms the second electrode.

The substrate may be a PET (polyethylene terephthalate) substrate.

The milk may be animal milk. The animal milk may be cow milk, more specifically natural cow milk.

The method may include preparing/making the switching layer. The method may therefore include the following steps:
- dipping/immersing an indium doped tin oxide (ITO) coated PET (polyethylene terephthalate) substrate into milk to form a thin film;
- allowing the milk thin-film on the ITO coated PET substrate to dry (e.g. at room temperature, preferably for about 48 hours), in order to form a stable film on the ITO-coated substrate; and
- depositing a conductive silver (Ag) paste as the second electrode on top of the switching layer.

In accordance with a fourth aspect of the invention there is provided a non-volatile resistive random-access memory (ReRAM) module/device which includes the non-volatile resistive random-access memory (ReRAM) in accordance with the first aspect of the invention.

In accordance with a fifth aspect of the invention there is provided a non-volatile resistive random-access memory (ReRAM) module/device which includes the non-volatile resistive random-access memory (ReRAM) switching layer composition in accordance with the second aspect of the invention.

In accordance with a sixth aspect of the invention there is provided a method for manufacturing a non-volatile resistive random-access memory (ReRAM) module/device, wherein the method includes:
providing a switching layer between a first electrode and a second electrode on a flexible substrate, wherein the switching layer contains milk or an emulsion including lactose, fat, protein and water.

The method may include any one or more of the method steps mentioned above in relation to the method in accordance with the third aspect of the invention.

### BRIEF DESCRIPTION OF THE DRAWINGS

The invention will now be described in more detail, by way of example, with reference to the accompanying drawings in which:
- **Figure 1**: shows a schematic diagram of a non-volatile random-access memory (RAM), in the form of a resistive RAM (ReRAM), in accordance with the invention.
- **Figure 2**: shows a photo of the resistive RAM in accordance with the invention.
- **Figure 3**: shows a graphical illustration of I-V characteristics of the ReRam of Figures 1 and 2.

### DESCRIPTION OF THE ILLUSTRATED EMBODIMENT

Referring to the drawings, in which like numerals indicate like features, a nonlimiting example of a non-volatile random-access memory, more specifically a resistive random-access memory in accordance with the invention is generally indicated by reference numeral 10. In one example, the ReRAM 10, in accordance with the invention, may include a first, bottom electrode 12, and a second, top electrode 14 which is placed/deposited over a switching/active layer 16 so that the switching/active layer 16 is located in between the two electrodes 12, 14.

The bottom electrode 12 is typically formed/coated on a substrate 18. More specifically, indium tin oxide (ITO) is typically coated onto a PET (polyethylene terephthalate) substrate 18, in order to form the bottom electrode 12. The top electrode 14 is typically made of a metal such as titanium, silver, aluminium, preferably silver.

The switching/active layer 16 is typically configured to perform a switching operation by changing a resistance between the electrodes 12, 14, according to an applied voltage.

The switching/active layer 16 contains/includes milk or an emulsion containing lactose, fat, protein and water. The milk may preferably be cow milk, more specifically natural cow milk.

The emulsion may further include a mineral(s) and a vitamin(s). The emulsion may specifically be natural cow milk.

The switching layer 16 is typically prepared by dipping/immersing the substrate 18, with the first/bottom electrode 12 coated thereon, into cow milk in order for the milk to form a thin film 20. The milk thin-film 20 on the ITO coated PET is then allowed to dry at room temperature for 48 hours, which allows the milk to form a stable film on the ITO-coated substrate, which forms the switching/active layer 16. In order to form a second/top electrode 14, a conductive silver (Ag) paste is deposited onto the switching/active layer 16 (i.e. the layer of milk), such that the switching/active layer 16 is located/wedged in-between the bottom electrode 12 and the top (Ag) electrode 14.

Since the switching/active layer 16 is made of milk, the use of potentially hazardous chemicals for forming the switching/active layer 16 is avoided, which makes the ReRAM 10 more environmentally friendly' and 'bio degradable', as well as non-toxic. The ReRAM can therefore form an important component for so-called" green computing".

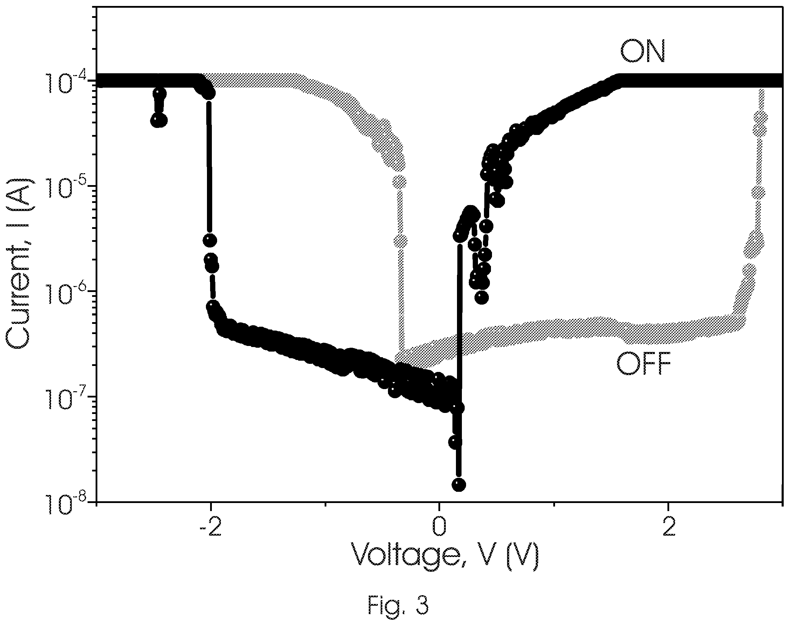

By implementing the above methodology during an experiment, the inventors found that the ReRAM 10 in accordance with the invention shows a remarkable unipolar switching at low voltages of 2.6 V with ON/OFF > 250, which is over two orders of magnitude, as illustrated in Figure 3. This low switching voltages makes the device a low power consuming device, which helps in energy saving.

Figure 2 shows a photo of the manufactured ReRAM 10.

The ReRAM 10 is flexible and can therefore be used in applications where it is necessary for the ReRAM 10 or a ReRAM device/module to adopt mechanical flexibility.

Further, the device/module can be fabricated to completion without the use of electricity or expensive and energy consuming techniques such as spin coat and atomic layer deposition.

In addition to the advantages highlighted above, the Inventor also believes that the present invention offers several other advantages over traditional non-volatile random-access memory (RAM) modules/devices, some of which are summarised below:
1. The ReRAM 10 can be manufactured to completion without the use of electricity.
2. The relatively simple fabrication does not require the use of expensive and energy consuming techniques such as spin coat, and atomic layer deposition.
3. The ReRAM 10 is compatible with transparent electronics.
4. The ReRAM 10 has potential application as a computer memory device.

## Claims

1. A non-volatile resistive random-access memory, ReRAM (10), which includes:
a first electrode (14);
a second electrode (12); and
a switching layer (16) which is located between the first and second electrode, wherein the switching layer
(i) contains milk or is milk-based, or
(ii) contains an emulsion containing lactose, fat, protein and water, **characterized in that** the ReRAM is flexible.

2. The ReRAM of claim 1, wherein the ReRAM is a biodegradable ReRAM.

3. The ReRAM of claim 2, wherein the first electrode is coated/provided on a polyethylene terephthalate, PET, substrate which forms part of the ReRAM.

4. The ReRAM of claim 2, wherein the switching layer contains cow milk.

5. The ReRAM of claim 4, wherein the switching layer is a dielectric of the ReRAM.

6. The ReRAM of claim 4 wherein the switching layer is configured to perform a switching operation according to an applied voltage.

7. The ReRAM of claim 4, wherein the first electrode is made, at least partially, from indium doped tin oxide, ITO.

8. A method for manufacturing a non-volatile resistive random-access memory, ReRAM (10), wherein the method includes:
providing a switching layer (16) between a first electrode (14) and a second electrode (12) on a flexible substrate (18), wherein the switching layer contains
milk, or
an emulsion containing lactose, fat, protein and water.

9. The method of claim 8, wherein the method is for manufacturing a biodegradable ReRAM.

10. The method of claim 9, wherein the substrate is a polyethylene terephthalate, PET substrate.

11. The method of claim 9, which includes dipping the first electrode into milk or the emulsion and allowing it to dry, to thereby allow the milk or emulsion to form the switching layer on/over the first electrode.

12. The method of claim 9, wherein the switching layer contains cow milk.

13. A non-volatile resistive random-access memory ReRAM module/device which includes the ReRAM as claimed in claim 1.

## Patentansprüche

1. Nicht flüchtiger resistiver Direktzugriffsspeicher, ReRAM (10), der einschließt:
eine erste Elektrode (14);
eine zweite Elektrode (12); und
eine Schaltschicht (16), die sich zwischen der ersten und der zweiten Elektrode befindet, wobei die Schaltschicht
(i) Milch enthält oder milchbasiert ist, oder
(ii) eine Emulsion enthält, die Laktose, Fett, Protein und Wasser enthält, **dadurch gekennzeichnet, dass** der ReRAM flexibel ist.

2. ReRAM nach Anspruch 1, wobei der ReRAM ein biologisch abbaubarer ReRAM ist.

3. ReRAM nach Anspruch 2, wobei die erste Elektrode auf einem Polyethylenterephthalatsubstrat, PET-Substrat, das Teil des ReRAM ausbildet, beschichtet/bereitgestellt ist.

4. ReRAM nach Anspruch 2, wobei die Schaltschicht Kuhmilch enthält.

5. ReRAM nach Anspruch 4, wobei die Schaltschicht ein Dielektrikum des ReRAM ist.

6. ReRAM nach Anspruch 4, wobei die Schaltschicht konfiguriert ist, um einen Schaltvorgang gemäß einer angelegten Spannung durchzuführen.

7. ReRAM nach Anspruch 4, wobei die erste Elektrode, mindestens teilweise, aus Indium-dotiertem Zinnoxid, ITO, hergestellt ist.

8. Verfahren zum Fertigen eines nicht flüchtigen resistiven Direktzugriffsspeichers, ReRAM (10), wobei das Verfahren einschließt:
Bereitstellen einer Schaltschicht (16) zwischen einer ersten Elektrode (14) und einer zweiten Elektrode (12) auf einem flexiblen Substrat (18), wobei die Schaltschicht Milch oder eine Emulsion enthält, die Laktose, Fett, Protein und Wasser enthält.

9. Verfahren nach Anspruch 8, wobei das Verfahren zum Fertigen eines biologisch abbaubaren ReRAM dient.

10. Verfahren nach Anspruch 9, wobei das Substrat ein Polyethylenterephthalatsubstrat, PET-Substrat, ist.

11. Verfahren nach Anspruch 9, das ein Eintauchen der ersten Elektrode in Milch oder die Emulsion und ein Ermöglichen zum Trocknenlassen einschließt, um dadurch der Milch oder Emulsion zu ermöglichen, die Schaltschicht auf/über der ersten Elektrode auszubilden.

12. Verfahren nach Anspruch 9, wobei die Schaltschicht Kuhmilch enthält.

13. Modul/Vorrichtung für nicht flüchtigen resistiven Direktzugriffsspeicher, ReRAM, das/die den ReRAM nach Anspruch 1 einschließt.

## Revendications

1. Mémoire vive résistive, ReRAM, non volatile (10), qui comporte :
une première électrode (14) ;
une seconde électrode (12) ; et
une couche de commutation (16) qui est située entre la première et la seconde électrode, dans laquelle la couche de commutation
(i) contient du lait ou est à base de lait, ou
(ii) contient une émulsion contenant du lactose, des matières grasses, des protéines et de l'eau, **caractérisée en ce que** la ReRAM est flexible.

2. ReRAM selon la revendication 1, dans laquelle la ReRAM est une ReRAM biodégradable.

3. ReRAM selon la revendication 2, dans laquelle la première électrode est revêtue de/fournie sur un substrat de polyéthylène téréphtalate, PET, qui fait partie de la ReRAM.

4. ReRAM selon la revendication 2, dans laquelle la couche de commutation contient du lait de vache.

5. ReRAM selon la revendication 4, dans laquelle la couche de commutation est un diélectrique de la ReRAM.

6. ReRAM selon la revendication 4, dans laquelle la couche de commutation est configurée pour réaliser une opération de commutation selon une tension appliquée.

7. ReRAM selon la revendication 4, dans laquelle la première électrode est fabriquée, au moins partiellement, à partir d'oxyde d'étain dopé à l'indium, ITO.

8. Procédé permettant de fabriquer une mémoire vive résistive, ReRAM, non volatile (10), dans lequel le procédé comporte :
la fourniture d'une couche de commutation (16) entre une première électrode (14) et une seconde électrode (12) sur un substrat flexible (18), dans lequel la couche de commutation contient du lait, ou une émulsion contenant du lactose, des matières grasses, des protéines et de l'eau.

9. Procédé selon la revendication 8, dans lequel le procédé est destiné à la fabrication d'une ReRAM biodégradable.

10. Procédé selon la revendication 9, dans lequel le substrat est un substrat de polyéthylène téréphtalate, PET.

11. Procédé selon la revendication 9, qui comporte le trempage de la première électrode dans du lait ou l'émulsion et le fait de la laisser sécher, pour permettre ainsi au lait ou à l'émulsion de former la couche de commutation sur/au-dessus de la première électrode.

12. Procédé selon la revendication 9, dans lequel la couche de commutation contient du lait de vache.

13. Module/dispositif de mémoire vive résistive, ReRAM, non volatile qui comporte la ReRAM selon la revendication 1.
